# EUROPÄISCHE PATENTSCHRIFT

(11) **EP 2 906 025 B1**
(45) Veröffentlichungstag und Bekanntmachung des Hinweises auf die Patenterteilung: **01.05.2019**
(21) Anmeldenummer: 15154071.3
(22) Anmeldetag: 06.02.2015
(51) Int. Cl.: H05K 3/10, H05K 3/18

(54) **Verfahren zur selektiven Aktivierung mindestens eines Bereiches einer Oberfläche eines dielektrischen Substrats**
Method for selective activation of at least one region of a surface of a dielectric substrate
Procédé d'activation sélective d'au moins une zone d'une surface d'un substrat diélectrique

(30) Priorität: 07.02.2014 DE 102014101522
(43) Veröffentlichungstag der Anmeldung: 12.08.2015
(73) Patentinhaber: Ernst-Abbe-Hochschule Jena, 07745 Jena (DE); Technische Universität Ilmenau, 98693 Ilmenau (DE)
(72) Erfinder: Bliedtner, Jens, 07745 Jena (DE); Barz, Andrea, 07745 Jena (DE); Möhwald, Michael, 98693 Ilmenau (DE); Schmidt, Udo, 98693 Ilmenau (DE); Lerp, Marianne, 98693 Ilmenau (DE); Schilling, Martin, 99706 Sondershausen (DE)
(74) Vertreter: Schaller, Renate

(56) Entgegenhaltungen:
- EP-A2- 1 845 170
- DE-A1-102011 000 138
- DE-A1-102012 100 299
- US-A- 5 405 656
- US-A1- 2003 124 259
- US-A1- 2007 019 028
- US-A1- 2007 092 638
- MOBIUS A ET AL: "Plasma-printing and galvanic metallization hand in hand-A new technology for the cost-efficient manufacture of flexible printed circuits", ELECTROCHIMICA ACTA, ELSEVIER SCIENCE PUBLISHERS, BARKING, GB, Bd. 54, Nr. 9, 30. März 2009 (2009-03-30), Seiten 2473-2477, XP026000632, ISSN: 0013-4686, DOI: 10.1016/J.ELECTACTA.2008.08.050 [gefunden am 2008-09-03]

## Beschreibung

Die Erfindung betrifft ein Verfahren zur selektiven Aktivierung mindestens eines Bereiches einer Oberfläche eines dielektrischen Substrats, wie dies gattungsgemäß aus der DE 10 2012 100 299 A1 bekannt ist.

Das Bestreben, die klassische Aufbautechnik von elektronischen Schaltungen mit 3D-Bauteilen zu verbinden, hat in den letzten Jahren zur Entwicklung verschiedener Verfahren im MID-Bereich geführt. MID steht für "Molded Interconnect Devices" und beschreibt elektronische Bauteile, bei denen metallische Leiterbahnen auf Substrate, wie beispielsweise auf vorgefertigte spritzgegossene Träger aus Polymer aufgebracht werden. Einen Überblick gibt die DE 10 2011 000 138 A1. Beispiele für MID-Verfahren sind das 2-Komponentenspritzgießverfahren, das Heißprägen, das Folienhinterspritzen, das Maskenbelichtungs- und Flamecon-Verfahren sowie das Laser-MID-Verfahren. Die Leiterbahnen werden entweder subtraktiv durch Abtrag einer zuvor vollflächigen Metallisierung hergestellt oder additiv mittels einer selektiven Oberflächenbearbeitung erzeugt. Eine sehr effiziente Methode ist das LDS-Verfahren (laser direct structuring), bei dem die Laserstrukturierung eines mit Additiven versehenen spritzgegossenen Substrats erfolgt. Jedoch ist bei diesem Verfahren eine Zugabe von Aktivierungsadditiven (titan-, nickel-, chrom- und / oder eisenhaltige organische Verbindungen) im gesamten Substrat für die Erzeugung von Keimen (Metallkeime) zur Verkupferung durch eine nachfolgende Laseraktivierung erforderlich. Das Verfahren ist daher sehr kostenintensiv und die Bauteile lassen sich nur aufwendig recyceln. Aktivierte Bereiche der Oberfläche können chemisch verkupfert und anschließend elektrolytisch aufgebaut sowie metallisch veredelt werden. Unter einer Aktivierung werden Maßnahmen verstanden, durch die eine ausreichende Haftung einer Metallisierung auf einem dielektrischen Material erreichbar ist oder durch die überhaupt erst eine Metallisierung des dielektrischen Materials möglich wird.

In der vorgenannten DE 10 2012 100 299 A1 ist ein weiteres Verfahren zur selektiven Herstellung einer Leiterbahnstruktur offenbart. Auf einem Substrat wird vollflächig eine Beschichtung aufgebracht, in der metallische Wirkpartikel als Metallkeime enthalten sind. Entlang herzustellender Leiterbahnen wird anschließend mittels einer Laserstrahlung die Beschichtung entfernt, wobei die Metallkeime auf der Oberfläche des Substrats verbleiben und teilweise in dessen Oberfläche einsinken und so mit dieser verbunden werden. Nachdem die Beschichtung wieder entfernt wurde, wird eine Metallisierungslösung auf das Substrat gebracht. Die chemische Metallisierung erfolgt entlang der herzustellenden Leiterbahnen, wobei die mit der Oberfläche verbundenen Wirkpartikel als Keime für den Prozess der Metallisierung fungieren. Mit diesem Verfahren können selektiv Keime auf dem Substrat angeordnet werden, ohne dass in dem Material des Substrats solche Keime oder deren Vorstufen enthalten sein müssen. Allerdings ist es erforderlich, die Beschichtung erst vollflächig aufzubringen und dann wieder zu entfernen, was einen nicht unerheblichen technologischen Aufwand darstellt.

Aus der US 2007/0092638 A1 ist ein Verfahren zur selektiven Aktivierung eines Substrates beschrieben, bei dem auf das Substrat eine Schicht aufgebracht wird, die polymerisiert wird, und in dieser gebildeten festen Polymerschicht, die Palladiumkerne enthält, durch Bestrahlung eine selektive Aktivierung erfolgt. Nachteilig ist insbesondere die notwendige Trocknungszeit der Schicht und die Notwendigkeit der Entfernung der nicht aktivierten Bereiche der Polymerschicht.

Der Erfindung liegt die Aufgabe zugrunde, eine Möglichkeit zur selektiven Aktivierung der Oberfläche eines dielektrischen Substrats vorzuschlagen, mittels der die bestehenden Nachteile des Standes der Technik vermieden werden.

Die Aufgabe wird durch ein Verfahren nach Anspruch 1 gelöst. Kern der Erfindung ist, dass zur Erreichung einer selektiven Aktivierung weder aktivierende chemische Verbindungen unspezifisch in das gesamte Material des Substrats eingebracht werden müssen noch dass Schichten festen Materials auf das Substrat aufgebracht und wieder entfernt werden müssen.

Unter aktivierenden chemischen Verbindungen werden nachfolgend alle Stoffe und Elemente verstanden, die als Keim für eine Metallisierung des Substrats wirken können (nachfolgend auch als Metallkeim bezeichnet). Solche aktivierenden chemischen Verbindungen sind vorzugsweise Metallsalze, sie können jedoch auch Metallionen oder andere Moleküle oder Ionen sein, die durch Wirkung einer elektromagnetischen Strahlung mit der Oberfläche des Substrats über einen zu aktivierenden Bereich verbunden werden können, wodurch aus dem zu aktivierenden Bereich ein aktivierter Bereich wird.

Die aktivierende chemische Verbindung gilt als mit dem zu aktivierenden Bereich verbunden, wenn eine chemische Verbindung vorliegt, wenn ein adsorptives Anhaften der Keime vorliegt oder wenn ein Anteil der Keime durch eine chemische Verbindung verbunden ist und ein anderer Anteil der Keime adsorptiv anhaftet.

Ein dielektrisches Substrat kann beispielsweise durch spritzgegossene Bauteile, aber auch alle anderen Kunststoffteile, insbesondere Vakuumgussteile, laminierte CFK-Verbundwerkstoffe und 3D-Druckteile (additive manufacturing) gegeben sein.

Die Flüssigkeit kann in einem einfachen Fall auf das Substrat aufgetragen werden, indem man die Flüssigkeit schüttet, aufpinselt, aufstreicht oder dosiert aufsprüht. Letzteres eröffnet vorteilhaft die Möglichkeit, nur geringe Anteile des Substrats mit der Flüssigkeit versehen zu müssen und so einen effizienten Einsatz der Flüssigkeit zu erlauben. So kann die Flüssigkeit auf einen zu aktivierenden Bereich des Substrats aufgesprüht werden, der zeitgleich oder unmittelbar nach dem Aufsprühen mit der elektromagnetischen Strahlung bestrahlt wird, so dass die elektromagnetische Strahlung durch die Flüssigkeit hindurch auf einen zu aktivierenden Bereich auf der Oberfläche des Substrats gerichtet ist.

Das Substrat kann auch in ein Flüssigkeitsbad getaucht und mit der elektromagnetischen Strahlung durch die Flüssigkeit hindurch bestrahlt werden. Im Sinne dieser Beschreibung ist eine Überschichtung der Oberfläche des Substrats mit der Flüssigkeit ein Auftragen der Flüssigkeit.

Das Material des Substrats ist vorzugsweise ein Polymer. In weiteren Ausgestaltungen des erfindungsgemäßen Verfahrens kann das Material auch ein Verbundwerkstoff oder ein Kompositwerkstoff sein.

Es ist günstig, wenn die aktivierende chemische Verbindung ein Salz ist, da diese meist eine gute Löslichkeit besitzen. In einer bevorzugten Ausgestaltung des erfindungsgemäßen Verfahrens ist die aktivierende chemische Verbindung eine metallhaltige Verbindung, beispielsweise ein Metallsalz wie Palladium-, Silber- oder Kupfersalz. Günstig ist, wenn die aktivierende chemische Verbindung eine Metallkomplexverbindung ist.

Um den besonderen Erfordernissen für Anwendungen, beispielweise im medizinischen Bereich zu entsprechen, kann die Metallisierung auch mit Metallen wie Gold erfolgen, die keine toxischen Wirkungen auf Zellen oder Gewebe haben.

Als elektromagnetische Strahlung wird vorzugsweise eine Strahlung eines Lasers mit einer Wellenlänge aus einem Wellenlängenbereich von 157 nm bis 10600 nm ausgewählt. Vorteilhaft wird eine Strahlung mit einer Wellenlänge aus dem Wellenlängenbereich der UV-Strahlung (157 nm bis 380 nm) oder dem IR-Bereich zwischen 800 nm bis 10600 nm verwendet. Für bestimmte Materialien kann aber auch der sichtbare Wellenlängenbereich, bei einer grünen Wellenlänge von beispielsweise 532 nm, die man durch Frequenzverdopplung der Strahlung eines Festkörperlasers erzielen kann, gute Aktivierungsergebnisse liefern.

Durch Wirkung der elektromagnetischen Strahlung wird die Oberfläche des Substrats in dem zu aktivierenden Bereich verändert, z. B. aufgeraut. Es kann darüber hinaus zu Änderungen in der molekularen Zusammensetzung, der molekularen Struktur sowie der molekularen Ausrichtung des Materials des Substrats kommen. Anteile der aktivierenden chemischen Verbindung lagern sich an dem Substrat in dem bestrahlten und zu aktivierenden Bereich an, wodurch aus dem zu aktivierenden Bereich ein aktivierter Bereich wird.

Die elektromagnetische Strahlung wird als ein Brennfleck auf dem zu aktivierenden Bereich abgebildet. Dabei kann ein Brennfleck im Sinne der Beschreibung durch eine Strahlformung, beispielsweise eine Fokussierung der elektromagnetischen Strahlung, bewirkt sein. Ein Brennfleck kann aber auch durch einen divergierenden Strahl oder einen Strahl mit konstantem Strahlquerschnitt bewirkt sein. Ein Brennfleck ist die Abbildung des Querschnitts mindestens eines Strahlenbündels der elektromagnetischen Strahlung auf der Oberfläche des Substrats.

Durch das erfindungsgemäße Verfahren ist vorteilhaft erreicht, dass die Verbindung von aktivierenden chemischen Verbindungen an zu aktivierende Bereiche und gegebenenfalls eine Strukturierung der Oberfläche der zu aktivierenden Bereiche in nur einem Verfahrensschritt und unter Verwendung nur einer Flüssigkeit erreicht wird.

Das erfindungsgemäße Verfahren ist vorteilhaft verwendbar, um nach der Aktivierung, d. h. nach der Erzeugung mindestens eines aktivierten Bereichs, eine Metallisierung des mindestens einen aktivierten Bereiches durchzuführen.

Dabei wird in einer möglichen Ausgestaltung des Verfahrens nach der Bestrahlung des mindestens einen aktivierten Bereiches die Flüssigkeit entfernt und der mindestens eine aktivierte Bereich chemisch metallisiert. Eine chemische Metallisierung wird beispielsweise durch ein Überschichten des Substrats mit einer metallhaltigen sowie Reduktionsmittel enthaltenden Lösung erreicht, wodurch eine außenstromlose Metallisierung erfolgt.

In einer weiteren Ausgestaltung des erfindungsgemäßen Verfahrens wird nach der Bestrahlung des mindestens einen aktivierten Bereiches die Flüssigkeit entfernt und der mindestens eine aktivierte Bereich elektrolytisch (galvanisch) metallisiert.

Eine elektrolytische Metallisierung kann auch aufbauend auf einer chemischen Metallisierung erfolgen.

Das erfindungsgemäße Verfahren und seine Ausgestaltungen zur Metallisierung der aktivierten Bereiche können sehr vorteilhaft zur Herstellung von elektronischen Schaltungen verwendet werden. Dabei können durch die Metallisierung Schaltungsstrukturen wie Leitungsbahnen, Kontakte, RFID-Strukturen, kapazitiv wirkende Strukturen und spezielle Anordnungsvarianten für sensorische Eigenschaften bzw. Elemente geschaffen werden.

Das Substrat kann nachfolgend mit elektrischen oder elektronischen Bauteilen bestückt werden, die über die Leitungsbahnen verschaltet sind. Das Substrat kann mit den elektronischen Bauteilen direkt bestückt und verbunden werden, beispielsweise über bekannte Lot- und Klebeverbindungstechniken. Die elektronischen Bauteile können beispielsweise auch auf das Substrat abgeschieden werden. Zur Abscheidung elektronischer Bauteile können bei entsprechender Eignung des Substrats beispielsweise Verfahren wie CVD (chemical vapor deposition) oder PECVD (plasma enhanced-CVD) eingesetzt werden.

Die Oberfläche des Substrats kann nach der Bearbeitung mit einem Schutzlack versiegelt werden, wie dies aus der Leiterplattentechnik bekannt ist.

Durch das erfindungsgemäße Verfahren ist es ermöglicht, dass die Metallkeime nur in den zu aktivierenden Bereichen mit dem Substrat verbunden werden. Eine Beimischung von Metallkeimen oder deren Vorstufen in das Substrat ist nicht erforderlich, wodurch die ursprünglichen Eigenschaften des Substrats beibehalten werden. Es können daher herkömmliche Kunststoffe, Verbundwerkstoffe oder Kompositwerkstoffe als Substrat verwendet werden, wodurch die Kosten gering gehalten werden können. Auch müssen keine festen Hilfsschichten auf das Substrat aufgebracht und gegebenenfalls wieder entfernt werden. Erstmalig können Kunststoffformkörper ohne Zusatzwerkstoffe oder Hilfsschichten über zu aktivierende Bereiche aktiviert werden. Diese können dann als Substrat für elektronische Schaltungen in einer Vielzahl von Anwendungen eingesetzt werden.

Das erfindungsgemäße Verfahren eröffnet die Möglichkeit, Kunststoffformkörper, wie beispielsweise Gehäuseteile mit elektrischen und / oder elektronischen Schaltungen, im Sinne einer zweidimensionalen oder auch dreidimensionalen Schaltungsanordnung zu verwirklichen. Es können so elektrisch leitfähige Strukturen wie Leiterbahnen oder Kontaktstellen auf beliebig geformte Kunststoffformkörper aufgebracht werden. Weisen diese Strukturen eine ausreichende Schichthaftung zu dem Kunststoffformkörper auf und lassen sich in nachfolgenden Verfahrensschritten passive und aktive elektronische Bauteile verschalten, kann eine aufwendige Herstellung von Leiterplatten entfallen und der Kunststoffformkörper kann unmittelbar als Substrat einer elektronischen Schaltung verwendet werden. Neben einer ressourcenschonenden Herstellungsweise sind durch das erfindungsgemäße Verfahren auch neue Designs von Schaltungen möglich. Zudem können Kunststoffformkörper und / oder die elektronischen Bauteile weiter miniaturisiert werden. Einsatzgebiete des erfindungsgemäßen Verfahrens liegen insbesondere im Gebiet der Kunststoffverarbeitung und dort speziell im Bereich des Spritzgießens. Grundsätzlich sind auch andere Verfahren der Kunststoffverarbeitung und der Herstellung von Formkörpern aus Kunststoff, wie beispielsweise Vakuumguss, Spritzprägen und Rapid-Prototyping-Verfahren, möglich. Anwendungsfelder sind beispielsweise der Automobilbau, die Medizintechnik, die Haushaltstechnik, Elektronik und Sensorik sowie die Kommunikationstechnik. Die kleinste erreichbare Strukturgröße wird im Wesentlichen durch den minimal einstellbaren Fokusdurchmesser bestimmt. Durch definiertes Schraffieren mit entsprechenden Scanmustern lassen sich in der Größe beliebig skalierbare aktivierbare Bereiche aktivieren.

Zur Durchführung des Verfahrens wird eine Vorrichtung zur selektiven Aktivierung mindestens eines Bereiches einer Oberfläche eines dielektrischen Substrats mittels einer elektromagnetischen Strahlung verwendet. Eine solche Vorrichtung weist eine Strahlungsquelle zur Bereitstellung der elektromagnetischen Strahlung und eine abbildende Optik zur Abbildung der elektromagnetischen Strahlung als ein Brennfleck auf einem zu aktivierenden Bereich der Oberfläche des Substrats auf.

Außerdem ist mindestens eine Sprühdüse zum Aufsprühen einer Flüssigkeit mindestens über die Ausdehnung des Brennflecks auf den zu aktivierenden Bereich vorhanden, wobei die Flüssigkeit mindestens eine aktivierende chemische Verbindung enthält.

Um die zu aktivierenden Bereiche mit dem Brennfleck vollständig zu überstreichen, sind Mittel vorhanden, um eine gesteuerte Relativbewegung von Brennfleck und zu aktivierendem Bereich zueinander zu erzeugen. Dazu kann das Substrat in einer verfahrbaren Halterung gehalten sein. Es ist auch möglich, dass die Strahlungsquelle mit der abbildenden Optik verfahrbar ist. Weiterhin ist die Anordnung eines Strahlführungselements, beispielsweise eines Scanners, möglich, durch den mindestens ein Strahlenbündel der elektromagnetischen Strahlung gezielt ausgelenkt und geführt werden kann.

Die Sprühdüse kann in einer Ausführung der Vorrichtung seitlich einer optischen Achse angeordnet sein, entlang der die elektromagnetische Strahlung durch die abbildende Optik von der Strahlungsquelle jeweils auf den zu aktivierenden Bereich gerichtet ist.

In einer weiterführenden Ausgestaltung ist die Sprühdüse koaxial um die optische Achse angeordnet. Dadurch ist vorteilhaft erreicht, dass mindestens ein Anteil der aufgesprühten Flüssigkeit auch bei einem plötzlichen Richtungswechsel der Relativbewegung von Brennfleck und zu aktivierendem Bereich auf dem zu aktivierenden Bereich aufgesprüht ist, bevor dieser durch den Brennfleck überstrichen wird. Ein Sprühen erfolgt, indem die Flüssigkeit mit Druck durch die Sprühdüse geleitet wird.

Es können weiterhin Einlassdüsen zur Einleitung eines Gases oder eines Gasgemisches an oder in der Sprühdüse vorhanden sein. Durch das Gas oder das Gasgemisch wird die Flüssigkeit mitgerissen und wird als ein Flüssigkeits-Gasgemisch auf den zu aktivierenden Bereich aufgesprüht. Das Flüssigkeits-Gasgemisch kann dabei nach dem Prinzip der Erzeugung eines Flüssigkeits-Gasgemisches eines Vergasers oder einer Wasserstrahlpumpe erzeugt sein.

Der abbildenden Optik kann ein dynamisches Fokussiersystem zugeordnet sein, mittels dem eine Fokussierung der elektromagnetischen Strahlung, genauer gesagt von Strahlenbündeln der elektromagnetischen Strahlung ermöglicht ist. Außerdem kann ein Strahlführungselement, beispielsweise ein Laserscanner, zur gezielten Führung mindestens eines Strahlbündels der elektromagnetischen Strahlung vorhanden sein. Wird der Laserscanner als ein 3D-Scanner ausgeführt, lassen sich somit auch nahezu beliebig dreidimensional geformte Substrate sehr schnell aktivieren.

Die Erfindung wird nachfolgend anhand von Ausführungsbeispielen und Abbildungen näher erläutert. Es zeigen:
- Fig. 1: eine schematische Darstellung eines Substrats und zweier zu aktivierender Bereiche,
- Fig. 2: eine schematische Darstellung des Substrats mit einer Flüssigkeitsschicht,
- Fig. 3: eine schematische Darstellung des Substrats während der Aktivierung durch Bestrahlung mit einer elektromagnetischen Strahlung,
- Fig. 4: eine schematische Darstellung des Substrats während der Metallisierung aktivierter Bereiche mit einer Metallisierungslösung,
- Fig. 5: eine schematische Darstellung des Substrats mit einem elektronischen Bauteil auf Leiterbahnen,
- Fig. 6: ein Blockschema der Herstellung eines Produkts unter Verwendung des erfindungsgemäßen Verfahrens,
- Fig. 7: ein erstes Ausführungsbeispiel einer Vorrichtung mit einer seitlich angeordneten Sprühdüse,
- Fig. 8: ein zweites und ein drittes Ausführungsbeispiel einer Vorrichtung mit einer koaxial angeordneten Sprühdüse und
- Fig. 9: eine schematische Darstellung einer beidseitigen Aktivierung eines Formkörpers mit zwei simultanen elektromagnetischen Strahlungen und einer Durchkontaktierung zweier Ebenen des Formkörpers in einer Schnittdarstellung.

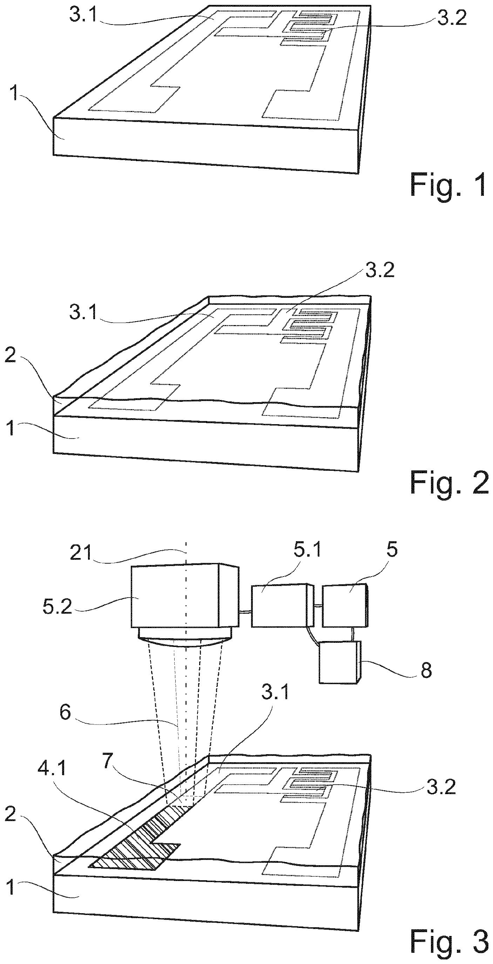

Bei der Durchführung eines ersten Ausführungsbeispiels des erfindungsgemäßen Verfahrens wird zuerst ein Kunststoffformkörper aus einem elektrisch nichtleitenden Polymer als ein Substrat 1 bereitgestellt, wie dieser stark schematisch und vereinfacht in Fig. 1 gezeigt ist. Auf einer Oberfläche des Substrats 1 ist ein erster zu aktivierender Bereich 3.1 und ein zweiter zu aktivierender Bereich 3.2 vorgesehen (deren Konturen sind durch Punktlinien angedeutet). Die Lage, Form und Dimensionierung der zu aktivierenden Bereiche 3.1, 3.2 werden vor der Durchführung des Verfahrens mittels eines entsprechenden Rechenprogramms zur Konstruktion elektronischer Schaltungen festgelegt. In weiteren Ausführungen des Verfahrens können die zu aktivierenden Bereiche 3.1, 3.2 auch manuell festgelegt werden.

In einem weiteren Schritt des erfindungsgemäßen Verfahrens wird über der Oberfläche mit dem ersten und dem zweiten zu aktivierenden Bereich 3.1 und 3.2 eine Schicht einer Flüssigkeit 2 aufgebracht (Fig. 2). Die Flüssigkeit 2 besteht aus einer wässrigen Lösung, in der ein dissoziiertes Palladiumsalz vorhanden ist und daher hydratisierte Palladium-Ionen vorliegen.

In einer weiteren Ausführung des Verfahrens kann ein Palladiumkomplex in der Flüssigkeit 2 vorhanden sein, so dass komplex gebundene Palladium-Ionen in der Flüssigkeit 2 vorliegen.

Anschließend wird, wie in Fig. 3 stark vereinfacht gezeigt, eine elektromagnetische Strahlung 6 auf die zu aktivierenden ersten und zweiten zu aktivierenden Bereiche 3.1 und 3.2 gerichtet. In Fig. 3 ist dazu eine Strahlungsquelle 5 vorhanden, durch die eine Laserstrahlung als elektromagnetische Strahlung 6 erzeugt wird. Die von der Strahlungsquelle 5 erzeugte und bereitgestellte elektromagnetische Strahlung 6 ist durch eine abbildende Optik 5.2 entlang einer optischen Achse 21 durch die Flüssigkeit 2 hindurch auf einen Brennfleck 7 auf der Oberfläche des Substrats 1 gerichtet. Eine der Ausdehnungen des Brennflecks 7 stimmt mit der Breite des ersten zu aktivierenden Bereichs 3.1 überein. Der Brennfleck 7 ist durch die Abbildung eines divergierenden Strahlenbündels der elektromagnetischen Strahlung 6 auf der Oberfläche des Substrats 1 gebildet und wird über die gesamte Ausdehnung des ersten zu aktivierenden Bereichs 3.1 und des zweiten zu aktivierenden Bereichs 3.2 geführt. Die Größe des Brennflecks 7 ist mittels eines dynamischen Fokussiersystems 5.1 und einer mit der abbildenden Optik 5.2 und dem dynamischen Fokussiersystem 5.1 signaltechnisch verbundenen Steuerung 8 gezielt veränderbar.

Die Strahlungsquelle 5 steht ebenfalls mit der Steuerung 8 in Verbindung und ist durch diese ansteuerbar und regelbar.

In weiteren Ausgestaltungen kann das Strahlenbündel auch konvergieren. Je nach Fokuslage kann das Strahlenbündel über seinen Verlauf auch bereichsweise konvergieren und über andere Bereiche divergieren und / oder parallel geführt sein.

In weiteren Ausgestaltungen kann als ein Strahlführungselement ein Laserscanner mit einem dynamischen Fokussiersystem 5.1 und / oder einer abbildenden Optik 5.2 verwendet sein, der mit der Steuerung 8 signaltechnisch verbunden ist. Der Brennfleck 7 kann dann durch eine gesteuerte Bewegung der elektromagnetischen Strahlung 6 über die gesamte Ausdehnung des ersten zu aktivierenden Bereichs 3.1 und des zweiten zu aktivierenden Bereichs 3.2 geführt werden.

Zu einem in Fig. 3 gezeigten Zeitpunkt der Durchführung des erfindungsgemäßen Verfahrens ist der Brennfleck 7 bereits eine Strecke entlang des ersten zu aktivierenden Bereichs 3.1 entlanggeführt. Dabei wurde durch die Wirkung der elektromagnetischen Strahlung 6 in Wechselwirkung mit der Flüssigkeit 2 und dem Substrat 1 die mit der elektromagnetischen Strahlung 6 beaufschlagte Oberfläche verändert. Mit der veränderten Oberfläche sind nun Palladium-Ionen oder Palladium-Atome verbunden, die als Metallkeime wirken. Entlang der bereits bestrahlten Strecke ist aus dem ersten zu aktivierenden Bereich 3.1 ein erster aktivierter Bereich 4.1 erzeugt worden (schraffiert dargestellt).

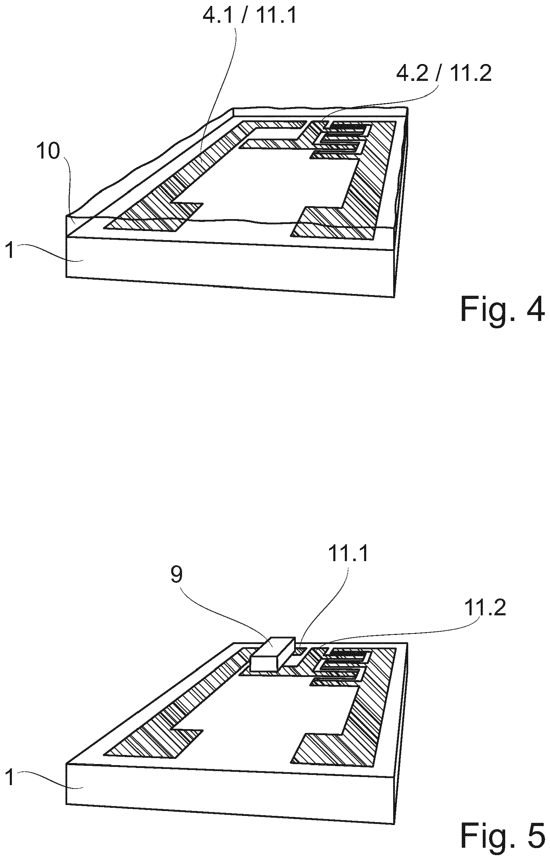

Nachdem der erste und der zweite zu aktivierende Bereich 3.1 und 3.2 (Fig. 3) jeweils entlang ihrer ganzen Ausdehnung durch die elektromagnetische Strahlung 6 beaufschlagt wurden, sind auf dem Substrat 1 ein erster aktivierter Bereich 4.1 und ein zweiter aktivierter Bereich 4.2 ausgebildet (Fig. 4). Anschließend wird die Strahlungsquelle 5 abgeschaltet und die Flüssigkeit 2 (siehe Fig. 3) abgespült. Die über den ersten und den zweiten aktivierten Bereich 4.1 und 4.2 mit der Oberfläche verbundenen Palladium-Ionen oder Palladium-Atome verbleiben dort. Über der Oberfläche mit dem ersten aktivierten Bereich 4.1 und dem zweiten aktivierten Bereich 4.2 wird eine Schicht einer Metallisierungslösung 10 aufgebracht, in der freie Kupfer-Ionen vorhanden sind. Nach bekanntem Prinzip wird eine chemische Metallisierung durchgeführt, bei der sich Kupfer-Ionen der Metallisierungslösung 10 durch Reduktion an den Palladium-Atomen auf den aktivierten Bereichen 4.1, 4.2 anlagern und die Oberfläche über die Ausdehnung der aktivierten Bereiche 4.1, 4.2 metallisiert wird. In den zu aktivierenden Bereichen 3.1, 3.2 angelagerte Palladium-Ionen werden in der Metallisierungslösung 10 zu Palladium-Atomen reduziert. Über dem ersten aktivierten Bereich 4.1 ist dann eine erste Leiterbahn 11.1 und über dem zweiten aktivierten Bereich 4.2 ist eine zweite Leiterbahn 11.2 ausgebildet. Nach der Erzeugung der ersten und der zweiten Leiterbahn 11.1, 11.2 durch die Metallisierung wird die Metallisierungslösung 10 abgespült und entfernt.

In weiteren Ausgestaltungen des erfindungsgemäßen Verfahrens kann die Metallisierungslösung 10 weitere oder andere Ionen und / oder Atome wie Gold enthalten. Es ist ferner möglich, eine Metallisierung der aktivierten Bereiche 4.1, 4.2 mittels anderer bekannter außenstromloser oder außenstromführender Galvanisierungsmethoden vorzunehmen.

Wie in der Fig. 5 gezeigt, kann auf das Substrat 1 mit der ersten und der zweiten Leiterbahn 11.1, 11.2 mindestens ein elektronisches Bauteil 9 aufgebracht werden. Das elektronische Bauteil 9 ist mit einem seiner Kontakte (nicht gezeigt) mit der ersten Leiterbahn 11.1 verbunden, während ein zweiter Kontakt (ebenfalls nicht gezeigt) mit der zweiten Leiterbahn 11.2 verbunden ist.

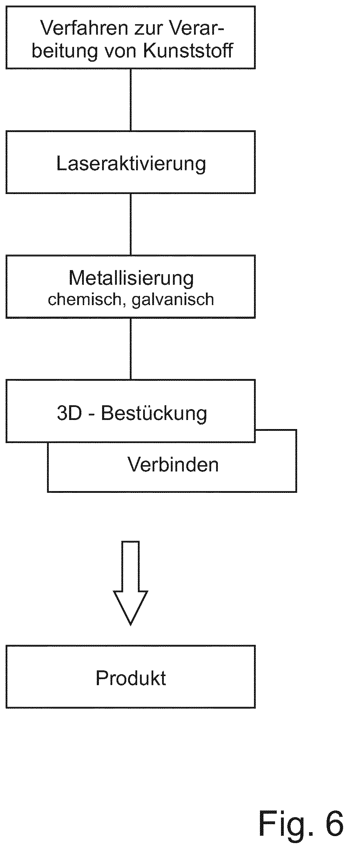

Die Herstellung eines Produkts unter Verwendung des erfindungsgemäßen Verfahrens ist in einem Blockschema in Fig. 6 zusammengefasst. In einem ersten Schritt wird mittels eines Verfahrens zur Verarbeitung von Kunststoff wie Spritzgießen ein Kunststoffformkörper als Substrat 1 hergestellt. Anschließend erfolgt die Aktivierung der zu aktivierenden Bereiche 3.1, 3.2 mittels eines Lasers als elektromagnetische Strahlung 6 und einer Flüssigkeit 2 (Laseraktivierung). Daran schließt sich eine Metallisierung aktivierter Bereiche 4.1, 4.2 und die Schaffung von Leiterbahnen 11.1, 11.2 an. Die Metallisierung kann chemisch und / oder galvanisch erfolgen. Die so hergestellten Leiterbahnen 11.1, 11.2 werden mit elektronischen Bauteilen 9 kontaktiert, wobei diese auf dem Substrat 1 dreidimensional (3D-Bestückung) aufgebracht und mit den Leiterbahnen 11.1, 11.2 durch Löten elektrisch leitend verbunden werden. Nachdem alle Leiterbahnen 11.1, 11.2 und die elektronischen Bauteile 9 miteinander kontaktiert sind, ist das Produkt hergestellt.

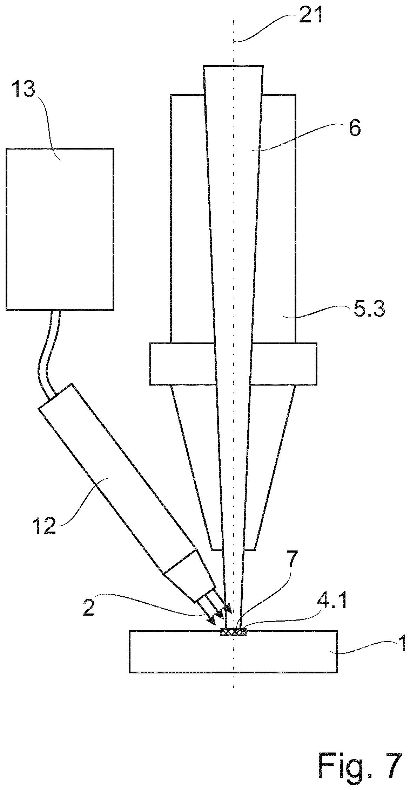

Fig. 7 veranschaulicht ein erstes Ausführungsbeispiel einer Vorrichtung, geeignet zur Durchführung eines erfindungsgemäßen Verfahrens, mit einer Sprühdüse 12 zur dosierten Zuführung der Flüssigkeit 2 auf den ersten zu aktivierenden Bereich 3.1 (nicht gezeigt). Die seitlich angeordnete Sprühdüse 12 ist so zur optischen Achse 21 und dem Brennfleck 7 ausgerichtet, dass die Flüssigkeit 2 gezielt in den Brennfleck 7 der elektromagnetischen Strahlung 6 applizierbar ist. Für die Führung und Fokussierung der elektromagnetischen Strahlung 6 ist ein Bearbeitungskopf 5.3 eingesetzt, der die abbildende Optik 5.2 und das dynamische Fokussierungssystem 5.1 (beide nicht gezeigt) beinhaltet. Über eine regelbare Dosiereinrichtung und Flüssigkeitsaufbereitungseinrichtung 13 wird die Flüssigkeit 2 bereitgestellt und zudem wird einerseits eine homogene Konzentration der Metallionen in der Flüssigkeit 2 gewährleistet und andererseits kann eine Durchflussmenge der Flüssigkeit 2 gezielt an aktuelle Betriebsparameter und Erfordernisse der Vorrichtung und der Verfahrensführung angepasst werden. Dadurch ist eine effiziente Flüssigkeitsverteilung und -menge während des Aktivierungsprozesses sichergestellt.

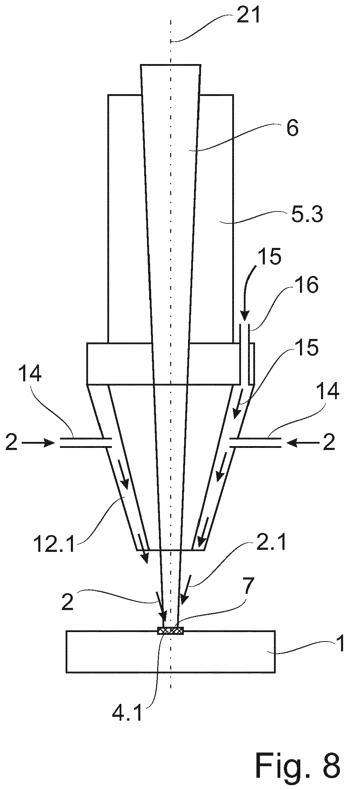

Ein zweites Ausführungsbeispiel einer Vorrichtung, geeignet zur Durchführung eines erfindungsgemäßen Verfahrens, ist in Fig. 8 (auf der linken Hälfte der Fig. 8, links von der optischen Achse 21) gezeigt und weist eine konzentrisch und koaxial zur optischen Achse 21 angeordnete koaxiale Sprühdüse 12.1 auf. Diese koaxiale Sprühdüse 12.1 ermöglicht einen gleichbleibenden Eintrag der Flüssigkeit 2 unabhängig von einer Bewegungsrichtung eines Strahlenbündels der elektromagnetischen Strahlung 6. In der koaxialen Sprühdüse 12.1 sind mehrere radiale Bohrungen 14 (nur zwei gezeigt) vorhanden, durch die die Flüssigkeit 2 der koaxialen Sprühdüse 12.1 zugeführt wird. Die zugeführte Flüssigkeit 2 wird dann durch Wirkung eines Gasstrahls 15 koaxial zur optischen Achse 21 auf den Brennfleck 7 gesprüht.

In einem ebenfalls in Fig. 8 schematisch gezeigten dritten Ausführungsbeispiel einer Vorrichtung (rechte Hälfte der Fig. 8), geeignet zur Durchführung eines erfindungsgemäßen Verfahrens, sind an der koaxialen Sprühdüse 12.1 Einlassdüsen 16 (nur eine gezeigt) zum Eintritt des Gasstrahls 15 vorhanden. Dadurch ist die Möglichkeit gegeben, ein Flüssigkeits-Gasgemisch 2.1 auf dem Brennfleck 7 zur Verfügung zu stellen und einen ersten aktivierten Bereich 4.1 (nur dieser beispielhaft gezeigt) zu erzeugen.

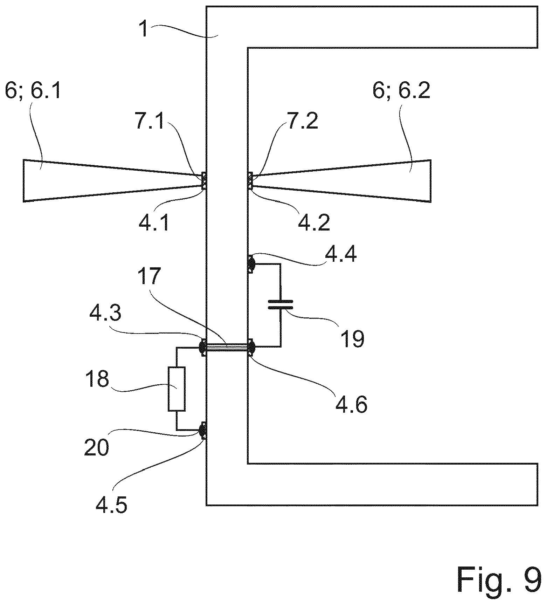

Figur 9 veranschaulicht die Aktivierung eines vereinfacht dargestellten Formkörpers als Substrat 1 in einer Schnittdarstellung. In dieser Anordnung wird das Substrat 1 auf einer Seite mit einem ersten Strahlenbündel 6.1 der elektromagnetischen Strahlung 6 und auf einer weiteren Seite mit einem zweiten Strahlenbündel 6.2 der elektromagnetischen Strahlung 6 simultan bestrahlt und aktiviert. Das erste Strahlenbündel 6.1 ist in einen ersten Brennfleck 7.1 und das zweite Strahlenbündel 6.2 ist in einen zweiten Brennfleck 7.2 gerichtet. Als elektromagnetische Strahlung 6 ist Laserstrahlung verwendet. Die Darstellung der Flüssigkeitszufuhr bleibt in dieser Darstellung unberücksichtigt.

Durch die beiden Strahlenbündel 6.1 und 6.2 werden ein erster bis ein sechster aktivierter Bereich 4.1, 4.2, 4.3, 4.4, 4.5 und 4.6 erzeugt. Durch die Schaffung der aktivierten Bereiche 4.1 bis 4.6 auf verschiedenen Seiten des Substrats 1 ist die Möglichkeit einer beidseitigen Bestückung des Substrates 1 mit elektronischen Bauteilen 9 sowie deren Verschaltung geschaffen. In Fig. 9 ist auf einer Seite des Substrats 1 ein Widerstand 18 gezeigt, der über den dritten aktivierten Bereich 4.3 und den fünften aktivierten Bereich 4.5 kontaktiert ist. Auf der gegenüberliegenden Seite des Substrats 1 ist ein Kondensator 19 vorhanden, der über den vierten aktivierten Bereich 4.4 und den sechsten aktivierten Bereich 4.6 kontaktiert ist. Über eine Durchkontaktierung 17 können elektronische Bauteile 9, hier der Widerstand 18 und der Kondensator 19, miteinander signaltechnisch verbunden werden. Nach den Aktivierungs- und Metallisierungsschritten können die Substrate 1 mit den elektronischen Bauteilen 9 dreidimensional bestückt, vorteilhaft mit Robotern oder 3D-Handlingsautomaten, und im Anschluss gelötet werden, so dass die Verschaltung der elektronischen Bauteile 9 sowie Kontaktstellen 20 zur Kontaktierung der Verschaltung entstehen.

### Bezugszeichenliste

- 1: Substrat
- 2: Flüssigkeit
- 2.1: Flüssigkeits-Gasgemisch
- 3.1: erster zu aktivierender Bereich
- 3.2: zweiter zu aktivierender Bereich
- 4.1: erster aktivierter Bereich
- 4.2: zweiter aktivierter Bereich
- 4.3: dritter aktivierter Bereich
- 4.4: vierter aktivierter Bereich
- 4.5: fünfter aktivierter Bereich
- 4.6: sechster aktivierter Bereich
- 5: Strahlungsquelle
- 5.1: dynamisches Fokussiersystem
- 5.2: abbildende Optik
- 5.3: Bearbeitungskopf
- 6: elektromagnetische Strahlung
- 6.1: erstes Strahlenbündel
- 6.2: zweites Strahlenbündel
- 7: Brennfleck
- 7.1: erster Brennfleck
- 7.2: zweiter Brennfleck
- 8: Steuerung
- 9: elektronisches Bauteil
- 10: Metallisierungslösung
- 11.1: erste Leiterbahn
- 11.2: zweite Leiterbahn
- 12: Sprühdüse
- 12.1: koaxiale Sprühdüse
- 13: Dosiereinrichtung und Flüssigkeitsaufbereitungseinrichtung
- 14: Bohrung (radial verteilt an der koaxialen Sprühdüse 12.1)
- 15: Gasstrahl
- 16: Einlassdüsen
- 17: Durchkontaktierung
- 18: Widerstand
- 19: Kondensator
- 20: Kontaktstelle
- 21: optische Achse

## Patentansprüche

1. Verfahren zur selektiven Aktivierung mindestens eines Bereiches einer Oberfläche eines dielektrischen Substrats (1) durch Verbinden des Bereichs mit mindestens einer aktivierenden chemischen Verbindung, wobei
- auf die Oberfläche des Substrats (1) eine Flüssigkeit (2), bestehend aus einer wässrigen Lösung, in der ein dissoziiertes Palladiumsalz oder ein Palladiumkomplex vorhanden ist, aufgetragen wird, in der die aktivierende chemische Verbindung enthalten ist, und
- durch die Flüssigkeit (2) hindurch in einen Brennfleck (7) auf die Oberfläche des Substrats (1) des mindestens einen zu aktivierenden Bereiches (3.1, 3.2) der Oberfläche eine elektromagnetische Strahlung (6) gerichtet wird, wobei die elektromagnetische Strahlung (6) in Wechselwirkung mit der Flüssigkeit (2) und dem Substrat (1) eine Veränderung der mit der elektromagnetischen Strahlung (6) beaufschlagten Oberfläche und Verbindung mit Palladium-Ionen oder Palladium-Atomen, die als Metallkeime wirken, bewirkt, so dass wenigstens ein Anteil der aktivierenden chemischen Verbindung mit dem zu aktivierenden Bereich (3.1, 3.2) verbunden und der zu aktivierende Bereich (3.1, 3.2) zu einem aktivierten Bereich (4.1 bis 4.6) aktiviert wird.

2. Verfahren nach Anspruch 1, **dadurch gekennzeichnet, dass** das Material des Substrats (1) ein Polymer ist.

3. Verfahren nach einem der vorhergehenden Ansprüche, **dadurch gekennzeichnet, dass** nach der Bestrahlung des mindestens einen aktivierten Bereiches (4.1 bis 4.6) die Flüssigkeit (2) entfernt und der mindestens eine aktivierte Bereich (4.1 bis 4.6) chemisch metallisiert wird.

4. Verfahren nach einem der vorhergehenden Ansprüche, **dadurch gekennzeichnet, dass** nach der Bestrahlung des mindestens einen aktivierten Bereiches (4.1 bis 4.6) die Flüssigkeit (2) entfernt und der mindestens eine aktivierte Bereich (4.1 bis 4.6) galvanisch metallisiert wird.

5. Verfahren nach einem der vorhergehenden Ansprüche, **dadurch gekennzeichnet, dass** das Auftragen der Flüssigkeit (2) ein Aufsprühen ist und die Bestrahlung mit der elektromagnetischen Strahlung (6) zeitgleich oder unmittelbar nach dem Aufsprühen erfolgt.

6. Verwendung des Verfahrens nach einem der Ansprüche 3 bis 5 zur Herstellung von elektronischen Schaltungen.

## Claims

1. Method for selective activation of at least one region of a surface of a dielectric substrate (1) by bonding the region to at least one activating chemical compound, wherein
- a liquid (2) is applied to the surface of the substrate (1), which liquid (2) consists of an aqueous solution in which a dissociated palladium salt or a palladium complex is present and contains the activating chemical compound, and
- an electromagnetic radiation (6) is directed through the liquid (2) into a focal spot (7) onto the surface of the substrate (1) of the at least one region to be activated (3.1, 3.2) of the surface, wherein the electromagnetic radiation (6) in interaction with the liquid (2) and the substrate (1) causes a change of the surface acted upon by the electromagnetic radiation (6) and bonding to palladium ions or palladium atoms which act as metal nuclei, so that at least a portion of the activating chemical compound is bonded to the region to be activated (3.1, 3.2) and the region to be activated (3.1, 3.2) is activated to an activated region (4.1 to 4.6).

2. Method according to claim 1, **characterized in that** the material of the substrate (1) is a polymer.

3. Method according to one of the preceding claims, **characterized in that** after the irradiation of the at least one activated region (4.1 to 4.6) the liquid (2) is removed and the at least one activated region (4.1 to 4.6) is chemically metallized.

4. Method according to one of the preceding claims, **characterized in that** after the irradiation of the at least one activated region (4.1 to 4.6) the liquid (2) is removed and the at least one activated region (4.1 to 4.6) is galvanically metallized.

5. Method according to one of the preceding claims, **characterized in that** the liquid (2) is applied by spraying and the irradiation with the electromagnetic radiation (6) is carried out simultaneously with or immediately after spraying.

6. Use of the method according to one of claims 3 to 5 for the production of electronic circuits.

## Revendications

1. Procédé d'activation sélective d'au moins une zone d'une surface d'un substrat (1) diélectrique en liant la zone à au moins un composé chimique activant, dans lequel
- un liquide (2) est appliqué à la surface du substrat (1), le liquide (2) consistant en une solution aqueuse, dans laquelle est présent un sel de palladium dissocié ou un complexe de palladium, et le liquide (2) contenant le composé chimique activant, et
- un rayonnement électromagnétique (6) est dirigé à travers le liquide (2) dans un point focal (7) sur la surface du substrat (1) de l'au moins une zone à activer (3.1, 3.2) de la surface, le rayonnement électromagnétique (6) en interaction avec le liquide (2) et le substrat (1) causant une modification de la surface, à laquelle est appliqué le rayonnement électromagnétique (6), et une liaison à des ions de palladium ou des atomes de palladium qui agissent comme noyaux métalliques, de telle façon qu'au moins une portion du composé chimique activant est liée à la zone à activer (3.1, 3.2) et la zone à activer (3.1, 3.2) est activée à une zone activée (4.1 à 4.6).

2. Procédé selon la revendication 1, **caractérisé en ce que** le matériau du substrat (1) est un polymère.

3. Procédé selon l'une des revendications précédentes, **caractérisé en ce que**, après l'irradiation de l'au moins une zone activée (4.1 à 4.6), le liquide (2) est enlevé et l'au moins une zone activée (4.1 à 4.6) est métallisée chimiquement.

4. Procédé selon l'une des revendications précédentes, **caractérisé en ce que**, après l'irradiation de l'au moins une zone activée (4.1 à 4.6), le liquide (2) est enlevé et l'au moins une zone activée (4.1 à 4.6) est métallisée de manière galvanique.

5. Procédé selon l'une des revendications précédentes, **caractérisé en ce que** le liquide (2) est appliqué par pulvérisation et l'irradiation avec le rayonnement électromagnétique (6) est effectuée simultanément avec ou immédiatement après la pulvérisation.

6. Utilisation du procédé selon l'une des revendications 3 à 5 pour la fabrication de circuits électroniques.
